# EUROPEAN PATENT SPECIFICATION

(11) **EP 0 256 733 B1**
(45) Date of publication and mention of the grant of the patent: **31.08.1994**
(21) Application number: 87306827.4
(22) Date of filing: 31.07.1987
(51) Int. Cl.: G01N 24/08

(54) **NMR Imaging of moving material using variable spatially selected excitation**
Bilderzeugung von bewegendem Material durch magnetische Kernresonanz mittels räumlich veränderlicher selektiver Anregung
Procédé d'imagerie par résonance magnétique nucléaire d'un matériau en mouvement utilisant une excitation spatialement variable

(30) Priority: 07.08.1986 US 894319
(43) Date of publication of application: 24.02.1988
(73) Proprietor: THE BOARD OF TRUSTEES OF THE LELAND STANFORD JUNIOR UNIVERSITY, Stanford California 94305 (US)
(72) Inventor: Nishimura, Dwight George, Palo Alto California 94306 (US)
(74) Representative: Cross, Rupert Edward Blount

(56) References cited:
- EP-A- 0 082 684
- EP-A- 0 124 016
- EP-A- 0 126 381
- MAGNETIC RESONANCE IN MEDICINE, vol. 4, no. 2, February 1987, pages 193-202, Academic Press Inc., New York, US; D.G. NISHIMURA et al.: "MR Angiography by selective inversion recovery"

## Description

This invention relates generally to nuclear magnetic resonance (NMR) or magnetic resonance (MR) imaging, and more particularly the invention relates to the selective projection imaging of moving material by variable spatially selected excitation.

Techniques are known for magnetic resonance angiography in which blood flow is imaged. U.S. Patent No. 4,528,985 utilizes temporal subtraction techniques for projection imaging of moving material in which image data at two different time intervals is obtained and subtracted so that data for static material cancels and data for moving material (e.g., blood) provides a residual image. In one arrangement disclosed in this document a first region next to a second region to be imaged is excited and moving material is allowed to flow from the first to the second region. The receiver is tuned to the second region whereby only the spins of moving material are detected. In another arrangement disclosed in this document at a first time interval a volume to be imaged is excited such that a free induction decay signal is generated but not used. Moving material from outside the volume is then allowed to flow in before the volume is excited for a second time to invert the spins in the static material. Thus only fresh nuclei from moving material generate a free induction decay signal which is used to provide a projection image of moving material in the volume.

U.S. Patent No. 4,516,582 excites nuclear spins in a thin slab and employs a gradient field to dephase excited spins of static material. In this method the nuclear spins in the thin slab are excited and after a time interval in which excited nuclear spins of blood flow from the thin slab, excited nuclear spins in the slab are again excited. Due to the dephasing or saturation of the static spins, substantially all of the subsequent resulting NMR signal will come from the excitation of spins of blood flow which moves into the slab during the time interval. This signal can be used to form a projection image of the slab.

U.S. Patent No. 4,647,857 for FLOW MEASUREMENT USING NUCLEAR MAGNETIC RESONANCE utilizes spin echo techniques to eliminate the effects of static nuclear spins whereby a residual signal from dynamic or moving nuclear spins is obtained.

EP 0126381 discloses an NMR method for measuring and imaging fluid flow. In this method an image is produced of a slice transaxial to the direction of fluid flow. The nuclei in the image slice are first tagged and then excited to produce a first signal. Nuclei in the slice and a volume upstream are then tagged and excited to produce a second signal. The first and second signals are then used to produce an image of the transaxial slice.

An object of the invention is a method of and apparatus for imaging moving material using variably spatially selected excitations.

Another object of the invention is an improved method of subtraction angiography.

In one aspect the present invention provides a method of imaging material in an X-Y-Z orthogonal axis system using magnetic resonance techniques wherein said material moves by pulsatile flow predominantly in a direction Z through a slab extending substantially perpendicular to the Z direction in a body; said method comprising the steps of
a) placing said body in a magnetic field (Bₒ) including a first magnetic field gradient (G_{z}) applied in conjunction with rf pulses for selecting portions of said body along the Z direction to be excited by said rf pulses,
b)applying a first said rf pulse to said body at a frequency band and of sufficient strength to flip by a first angle nuclear spins limited to a region adjacent to said slab in the Z direction,
c) allowing sufficient time for the moving material in said slab to flow from said slab and moving material from said region to flow into said slab;

characterised in that said first rf pulse is applied just prior to a period of rapid flow; and by the steps of
d) applying a. second said rf pulse to said body during a period of quiescent flow and at a frequency band and of sufficient strength to flip nuclear spins limited to said slab by a second angle suitable for generating a signal,
e) obtaining first image data in an X-Z image projection plane from said nuclear spins flipped by said second rf pulse,
f) repeating step c without exciting said region,
h) repeating step d,
i) obtaining second image data in an X-Z image projection plane from said nuclear spins flipped by the step h rf pulse,
j) subtracting said first image data from said second image data to obtain third image data of material moving through said slab, and
k) reconstructing an X-Z projection image using said third image data, after completing the data acquisition by means of a two dimensional imaging technique.

In a further aspect the present invention provides a method of imaging material in an X-Y-Z orthogonal axis system using magnetic resonance techniques, wherein said material moves by pulsatile flow predominantly in a direction Z through a slab extending substantially perpendicular to the Z direction in a body, said method comprising the steps of
a) placing said body in a magnetic field (Bₒ) including a first magnetic field gradient (G_{z}) applied in conjunction with rf pulses for selecting portions of said body along the Z direction to be excited by said rf pulses;
b) applying a first said rf pulse to said body at a frequency band and of sufficient strength to flip by a first angle nuclear spins limited to said slab,
c) allowing sufficient time for moving material in said slab to flow from said slab and moving material outside of said slab to flow into said slab;
d) applying a second said rf pulse to said body at a frequency band and of sufficient strength to flip nuclear spins limited to said slab by a second angle suitable for generating a signal,
e) obtaining first image data in an X-Z image projection plane from said nuclear spins flipped by said second rf pulse,
   characterized in that said first rf pulse is applied just prior to a period of rapid flow and said second rf pulse is applied during a period of quiescent flow, and by the steps of
f) applying a third said rf pulse to said body just prior to a period of rapid flow and at a frequency band that is non-selective of said slab and of sufficient strength to flip nuclear spins in said body, but not limited to said slab, by said first angle,
g) repeating step c,
h) repeating step d,
i) obtaining second image data in an X-Z image projection plane from said nuclear spins flipped by the step h rf pulse,
j) subtracting said first image data from said second image data to obtain third image data of material moving through said slab, and
k) reconstructing an X-Z projection image using said third image data, after completing the data acquisition by means of a two dimensional imaging technique.

In another aspect the present invention provides a magnetic resonance apparatus for imaging material in an X-Y-Z orthogonal axis system, wherein said material moves by pulsatile flow predominantly in a direction Z through a slab extending substantially perpendicular to the Z direction in a body, said apparatus comprising
a) magnet means adapted to provide a static magnetic field (Bₒ),
b) gradient coil means adapted to provide a first magnetic field gradient (G_{z}) applied in conjunction with rf pulses for selecting portions of said body along the Z direction to be excited by said rf pulses;
c) rf generating means programmed to apply a first said rf pulse to said body at a frequency band and of sufficient strength to flip by a first angle nuclear spins limited to a region adjacent to said slab in the Z direction;

characterised in that said rf generating means is programmed to apply said first rf pulse just prior to a period fo rapid flow, and to apply a second said rf pulse to said body during a period of quiescent flow after moving material in said slab has been allowed to flow from said slab and moving material from said region has been allowed to flow into said slab, said second rf pulse having a frequency band and sufficient strength to flip nuclear spins limited to said slab by a second angle suitable for generating a signal, and by
d) means to obtain first image data in an X-Z image projection plane from said nuclear spins flipped by said second rf pulse,
e) said rf generating means being further programmed to apply a third said rf pulse to said body during a period of quiescent flow, after moving material in said slab has been allowed to flow from said slab and moving material from said region has been allowed to flow into said slab, said third rf pulse having a frequency band and sufficient strength to flip nuclear spins limited to said slab by said second angle suitable for generating a signal,
f) means to obtain second image data in an X-Z image projection plane from said nuclear spins flipped by said third rf pulse,
g) processing means programmed to subtract said first image data from said second image data to obtain third image data of material moving through said slab, and h) means for reconstructing an X-Z projection image using said third image data, after completion of the data acquisition by means of a two dimensional imaging technique.

In a still further aspect the present invention provides magnetic resonance apparatus for imaging material in an X-Y-Z orthogonal axis system wherein said material moves by pulsatile flow predominantly in a direction Z through a slab extending substantially perpendicularly to the Z direction in a body, said apparatus comprising
a) magnet means adapted to provide a static magnetic field (Bₒ),
b) gradient coil means adapted to provide a first magnetic field gradient (G_{z}) applied in conjunction with rf pulses for selecting portions of said body along the Z direction to be excited by said rf pulses;
c) rf generating means programmed to apply a first said rf pulse to said body at a frequency band and of sufficient strength to flip by a first angle nuclear spins limited to said slab, and to apply a second said rf pulse to said body, after allowing moving material in said slab to move from said slab and moving material outside of said slab to flow into said slab, said second rf pulse having a frequency band and a sufficient strength to flip nuclear spins limited to said slab by a second angle suitable for generating a signal, and
d) means to obtain first image data in an X-Z image projection plane from said nuclear spins flipped by said second rf pulse,
   characterised in that
e) said rf generating means is programmed to apply said first rf pulse just prior to a period of rapid flow and to apply said second rf pulse during a period of quiescent flow, and is further programmed to apply a third said rf pulse to said body just prior to a period of rapid flow and at a frequency band that is non-selective of said slab and of sufficient strength to flip nuclear spins in said body, but not limited to said slab, by said first angle, and to apply a fourth said rf pulse identical to said second rf pulse to said body during a period of quiescent flow after allowing moving material in said slab to flow from said slab and moving material outside of said slab to flow into said slab,
   and further characterised by
f) means to obtain second image data in an X-Z image projection plane from said nuclear spins flipped by said fourth rf pulse,
g) processing means programmed to subtract said first image data from said second image data to obtain third image data of material moving through said slab, and
h) means for reconstructing an X-Z projection image using said third image data, after completion of the data acquisition by means of a two dimensional imaging technique.

A feature of one embodiment of the invention is the use of a first excitation pulse, 180° for example, for inverting nuclear spins in a slab. After a period of time during which flowing material from outside the slab flows into the slab, a second excitation pulse, 90° for example, is applied for generating a first image signal from the flowing material in the slab. Thereafter, the excitation sequence is repeated for the slab and for at least one adjacent region including material flowing into the slab to obtain a second image signal. The second image signal is subtracted from the first image signal to remove any residual signal from static material thereby obtaining a difference signal corresponding to flowing material. The necessary data acquisition is performed on the generated signal along the thickness axis of the slab to form a two dimensional (2-d) image of the volume using spin. warp imaging or other methods such as echo planar or generalized imaging with time variant gradients.

Since static material has different T₁ values in general, static material signals may remain in the generated image signals. To the extent that these remaining signals dominate the blood signals, they are eliminated by subtracting the signals. This is readily accomplished in accordance with the invention by acquiring the second image signal with the same static material component as in the first image but a different signal component from blood.

Examples of the present invention will now be described with reference to the drawings, in which:-

Figures 1A-1D illustrate the arrangement of NMR apparatus and magnetic fields generated therein.

Figure 2 is a functional block diagram of NMR imaging apparatus.

Figure 3 illustrates a basic pulse sequence for exciting a slab and the resultant projection image for use in accordance with one embodiment of the invention.

Figure 4 is a plot illustrating longitudinal relaxation with time after inversion using the pulse sequence of Figure 3.

Figure 5 is an illustration of a pulse sequence for obtaining a second image for subtraction imaging in accordance with the invention.

Figures 6A and 6B illustrate top views of slabs and adjoining regions with the shaded regions indicating regions excited by 180° pulses in accordance with one embodiment of the invention for obtaining two image signals.

Figures 7A and 7B are top views of slabs and adjoining regions with the shaded portions indicating regions excited by 180° pulses in accordance with another embodiment of the invention for obtaining two image signals.

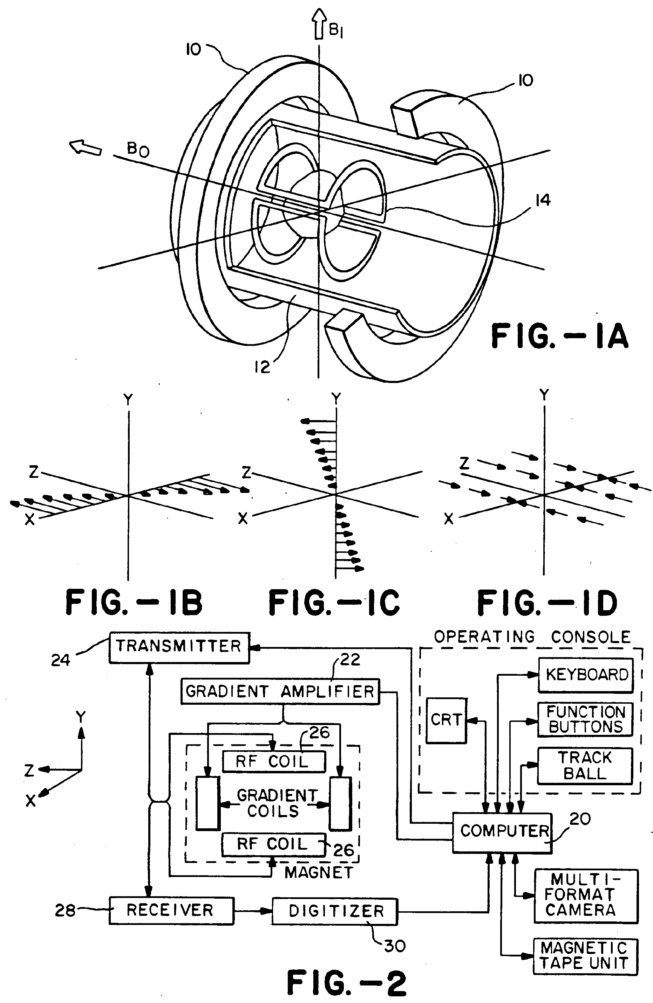

Referring now to the drawings, Figure 1A is a perspective view partially in section illustrating coil apparatus in NMR imaging system, and Figures 1B-1D illustrate field gradients which can be produced in the apparatus of Figure 1A. This apparatus is discussed by Hinshaw and Lent, "An Introduction to NMR Imaging: From the Bloch Equation to the Imaging Equation", Proceedings of the IEEE, Vol. 71, No.3, March 1983 pgs. 338-350. Briefly, the uniform static field Bₒ is generated by the magnet comprising the coil pair 10. A gradient field G(x) is generated by a complex gradient coil set which can be wound on the cylinder 12. An RF field B₁ is generated by a saddle coil 14. A patient undergoing imaging would be positioned along the Z axis within the saddle coil 14.

In Figure 1B an X gradient field is shown which is parallel to the static field Bₒ and varies linearly with distance along the X axis but does not vary with distance along the Y or Z axes. Figures 1C and 1D are similar representations of the Y gradient and Z gradient fields, respectively.

Figure 2 is a functional block diagram of the imaging apparatus as disclosed in NMR-A Perspective on Imaging, General Electric Company 1982. A computer 20 is programmed to control the operation of the NMR apparatus and process FID signals detected therefrom. The gradient field is energized by a gradient amplifier 22, and the RF coils for impressing a RF magnetic field at the Larmor frequency is controlled by the transmitter 24 and the RF coils 26. After the selected nuclei have been flipped, the RF coils 26 are employed to detect the FID signal which is passed to the receiver 28 and thence through digitizer 30 for processing by computer 20.

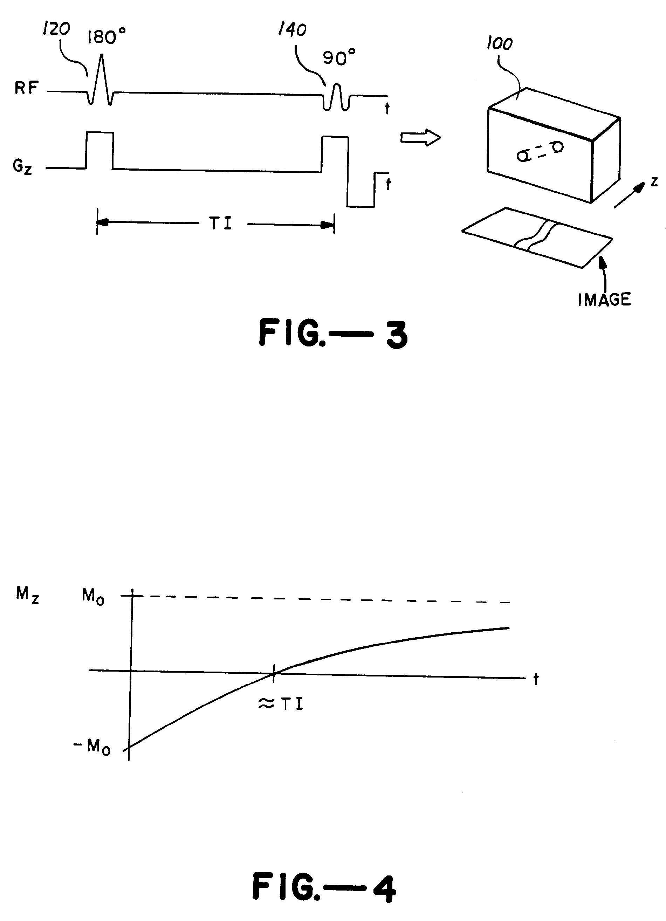

In accordance with one embodiment of the present invention, moving material such as blood flow is imaged by means of a variably spatially selective excitation. The embodiment uses time of flight effects to distinguish signals of flowing blood from signals of static material. The basic procedure is illustrated in Figure 3 and includes the following steps:
1. Selectively excite a slab 100 (perpendicular to the Z axis) with an inverting pulse 120 (180° or other large flip angle). This represents a preparatory pulse.
2. Wait TI seconds. This is the evolution period.
3. Selectively excite the same slab 100 with a pulse 140 or pulses suitable for generating a signal (for example 90° or a 90° - 180° combination for spin echo). The RF pulses are applied in the presence of a Z gradient, G_{Z}, as illustrated.
4. With the generated FID signal, the necessary data acquisition is performed to form a two dimensional (X-Z) image of the volume using spin warp imaging or other methods such as echo planar or generalized imaging with time varying gradients.

The image resulting from the above procedure will contain a relatively large signal from blood if flow is predominantly in the Z direction. After the 180° pulse, there occurs an inflow of fresh, unexcited nuclear spins from blood into the slab by the time the 90° pulse is applied to generate the signal. The extent of flow over TI seconds is approximately equal to the average Z velocity, V_{Z}, times TI, and this value determines the usual thickness of the excited slab. For example, if V_{Z} equal 20 cm/second and TI equal 400 msc, then the excited slab should be about 8 cm thick. If static material has a known and relatively uniform T₁ longitudinal relaxation time constant, then TI can be selected so that the 90° pulse occurs at the "null" point of the static material when the longitudinal relaxation crosses the zero point, as illustrated in Figure 4. However, because static material has different T₁ values, some static material signals will remain. To the extent that these remaining signals dominate the blood signals, it is desirable to subtract them from the image. Several techniques are available for removing the static material signals through subtraction by acquiring a second image with the same static material signals as in the first image but with having different signals from blood.

One technique which could be used and which is not an embodiment of the present invention involves repeating the same sequence as illustrated in Figure 3 for obtaining image 1 but with the sequence gated to the interval when the blood flow is relatively quiescent as compared to the flow during image 1. Thus, there does not occur much inflow of blood into the slab during TI. By selecting TI to be the null point of blood, blood signals in image 2 are significantly reduced. Static material signals remain the same in both images and will subtract out. Moreover, by keeping TI short, less T₁ relaxation occurs and a larger difference signal can be detected.

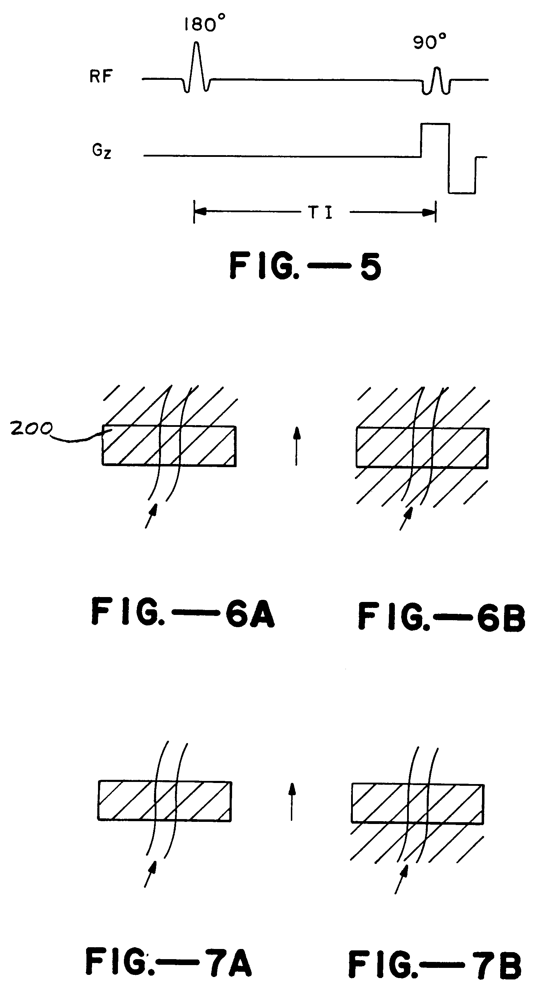

According to one embodiment of the present invention, a change in the imaging sequence must be made in a way that affects only flowing blood and not stationary material. One such change is to alter the spatial selectivity of the inverting 180° pulse for the second image. For example, by exciting with a non-selective 180° pulse, as illustrated in Figure 5, blood flowing into the slab defined by the 90° pulse will have experienced both excitations and, assuming TI corresponds to the null point of blood or is short enough to avoid significant relaxation, will yield a different blood signal. Thus, for image 1 the original selected 180° pulse is still used. Hence, the change in the imaging parameters that differentiate flowing blood is the spatial selectivity of the 180° pulse. This subtraction approach allows for gating to the same portion of the cardiac cycle for both images, thereby minimizing the possibility of misregistration artifacts.

Further minimization is possible by interleaving the measurements for both images. Either phase dependent subtraction or magnitude dependent subtraction can be employed.

Other variations are possible with the latter method for subtraction imaging. For example, it is possible to establish directional sensitivity by making the 180° pulse for image 1 to be a "semi-selective" excitation whereby the slab and one adjacent region are excited, as illustrated in Figure 6A for the slab 200 with the excited region denoted by shading. In this case, material flowing in from the excited region will be the same in both images and will therefore subtract out, leaving only signals which have flowed into the slab from a region on the opposite side of the slab. Alternatively, to achieve the same directional sensitivity, the spatial selectivity of the 180° pulse for the second image can be adjusted to excite the slab and the opposite side as illustrated in Figures 7A and 7B. In this case, material flowing in from the unexcited side can be large, but the same in both images, and will therefore cancel out. In general, to eliminate material flowing in from a particular side, the outer slab region from which it flows must experience the same excitations for both images.

After the selective 90° pulse, a spin echo may be created by applying a 180° pulse. This 180° pulse can serve a dual purpose to generate the spin echo in the slab and to invert the out of slab region if the 180° is non-selective. The two images are derived by varying the spatial selectivity of this 180° pulse. In the first case, the 180° pulse is made selective to the same slab and therefore the signal from the next 90° pulse, 180° pulse combination will contain a large blood signal as unexcited spins flow into the slab. In the second case, the 180° pulse is made non-selective (or less selective) creating a spin echo in the in-slab region and simultaneously inverting the spins to the out-of slab region, thus preparing the following 90° pulse, 180° pulse combination which will yield a small signal as described before. The selectivity of the 180° pulse can be alternated between measurements to interleave the two measurement sets. Gating is required for pulsatile flow. This method would be most useful if the heart rate is relatively fast so that the interval between a 90° pulse, 180° pulse combination is short enough to avoid a significant T₁ relaxation of the blood component.

The basic sequence can be modified by having the 180° inversion pulse excite only the region adjacent to the slab excited by the 90° pulse. The inversion tags that adjacent region so that any material from the tagged region flows into the slab in time for the 90° pulse to generate a signal. For the second image, the 180° pulse is simply not applied; instead, only the 90° pulse is used and the signal is quickly read out. This second image will contain a relatively large static material signal since the null point signal reduction does not apply in the system but the two static material signals cancel. The flowing material signal components will be different and thus will not cancel.

Because projection imaging is of interest, the excited slab can be imaged by 2-D techniques with spatial localization provided along the z-direction and one perpendicular direction. Since the field-of-view in the z-direction is limited by the thickness of the slab, the imaging requirements for that direction are less severe than normal. If spinwarp (2D-FT) imaging is employed, phase-encoding can be applied along the same direction as slice-selection to reduce the number of measurements for the same resolution or to increase resolution with same number of measurements. Also, in contrast with other angiographic methods that rely on specific gradient waveforms to produce flow sensitivity, the method in accordance with the invention relies solely on time-of-flight effects and can therefore incorporate a wider range of gradient waveforms with which to image, including those that allow for fast imaging. The imaging gradient waveforms are best chosen however to be insensitive to motion (such as by making the first moments of the gradient zero) because the time-of-flight effects already provide the necessary flow sensitivity. The velocity direction sensitized by these methods is not solely along the z axis. The difference signal arises in the regions that have been flowed into by fresh spins during TI. Therefore, the regions visualized can be oriented in various directions as long as the particular region is supplied by spins from outside the slab within time TI.

According to the invention, wherein material moves through a region by pulsatile flow, the 180° inversion pulse, being an example of the first rf pulse according to the claims, is applied just prior to the moment of rapid flow (e.g. systole) to maximize the extent of inflow, and the 90° pulse during the period of quiescent flow (e.g. diastole) to avoid artifacts and loss of signal due to potential velocity-dependent phase shifts from the applied gradient fields.

There has been described an improved material imaging method and apparatus in which the spatial selectivity of the excitation pulses are controlled to remove static material and generate differential signals from flowing blood. The invention has applicability to a variety of vascular regions including coronary arteries, and the method is well suited for coronary artery imaging given the limited field of view required. Moreover, embodiments of the invention involving adjacent region excitation are particularly suitable because the blood feeding the arteries comes from a large well-defined region at the root of the aorta . The invention has embodiments for pulsatile conditions and it can be set up to provide one way directional sensitivity. While the resulting image represents a limited field of view, image acquisition time is reduced versus wide field of view imaging using conventional techniques, and the procedure can be repeated for other slabs to increase the field of view as required.

## Claims

1. A method of imaging material in an X-Y-Z orthogonal axis system using magnetic resonance techniques wherein said material moves by pulsatile flow predominantly in a direction Z through a slab (100) extending substantially perpendicular to the Z direction in a body; said method comprising the steps of
a) placing said body in a magnetic field (Bₒ) including a first magnetic field gradient (G_{z}) applied in conjunction with rf pulses (120, 140) for selecting portions of said body along the Z direction to be excited by said rf pulses (120, 140),
b) applying a first said rf pulse (120) to said body at a frequency band and of sufficient strength to flip by a first angle nuclear spins limited to a region adjacent to said slab (100) in the Z direction,
c) allowing sufficient time for the moving material in said slab (100) to flow from said slab (100) and moving material from said region to flow into said slab (100);
characterised in that said first rf pulse (120) is applied just prior to a period of rapid flow; and by the steps of
d) applying a second said rf pulse (140) to said body during a period of quiescent flow and at a frequency band and of sufficient strength to flip nuclear spins limited to said slab (100) by a second angle suitable for generating a signal,
e) obtaining first image data in an X-Z image projection plane from said nuclear spins flipped by said second rf pulse (140),
f) repeating step c without exciting said region,
h) repeating step d,
i) obtaining second image data in an X-Z image projection plane from said nuclear spins flipped by the step h rf pulse,
j) subtracting said first image data from said second image data to obtain third image data of material moving through said slab (100), and
k) reconstructing an X-Z projection image using said third image data, after completing the data acquisition by means of a two dimensional imaging technique.

2. The method as defined by Claim 1 wherein said step d includes applying a 90° rf pulse and a 180° pulse for spin echo signal detection.

3. A method of imaging material in an X-Y-Z orthogonal axis system using magnetic resonance techniques, wherein said material moves by pulsatile flow predominantly in a direction Z through a slab (100) extending substantially perpendicular to the Z direction in a body, said method comprising the steps of
a) placing said body in a magnetic field (Bₒ) including a first magnetic field gradient (G_{z}) applied in conjunction with rf pulses (120, 140) for selecting portions of said body along the Z direction to be excited by said rf pulses (120, 140),
b) applying a first said rf pulse (120) to said body at a frequency band and of sufficient strength to flip by a first angle nuclear spins limited to said slab (100),
c) allowing sufficient time for moving material in said slab to flow from said slab and moving material outside of said slab (100) to flow into said slab (100);
d) applying a second said rf pulse (140) to said body at a frequency band and of sufficient strength to flip nuclear spins limited to said slab (100) by a second angle suitable for generating a signal,
e) obtaining first image data in an X-Z image projection plane from said nuclear spins flipped by said second rf pulse (140),
characterised in that said first rf pulse is applied just prior to a period of rapid flow and said second rf pulse is applied during a period of quiescent flow, and by the steps of
f) applying a third said rf pulse to said body just prior to a period of rapid flow and at a frequency band that is non-selective of said slab (100) and of sufficient strength to flip nuclear spins in said body, but not limited to said slab (100), by said first angle,
g) repeating step c,
h) repeating step d,
i) obtaining second image data in an X-Z image projection plane from said nuclear spins flipped by the step h rf pulse,
j) subtracting said first image data from said second image data to obtain third image data of material moving through said slab (100), and
k) reconstructing an X-Z projection image using said third image data, after completing the data acquisition by means of a two dimensional imaging technique.

4. The method as defined by Claim 3, wherein said third rf pulse, instead of being non-selective of said slab, is selective of said slab (100) and a region adjacent to said slab (100) in the Z direction.

5. The method as defined by Claim 3, wherein step d includes flipping nuclear spins of moving material that flows into said slab (100) during step c.

6. The method as defined by Claim 3 wherein step b further includes flipping nuclear spins in a first region adjacent to said slab (200) in the Z direction, and step j obtains third image data of moving material flowing into said slab (200) from a region on the opposite side of said slab (200) with respect to said first region.

7. The method as defined by Claim 1 or Claim 3 wherein said first angle is approximately 180° and said second angle is approximately 90°.

8. The method as defined by Claim 7, insofar as Claim 7 refers back to Claim 3, wherein said steps d) and h) occur when the magnetic moments of excited static material are approximately zero.

9. Magnetic resonance apparatus for imaging material in an X-Y-Z orthogonal axis system, wherein said material moves by pulsatile flow predominantly in a direction Z through a slab (100) extending substantially perpendicular to the Z direction in a body, said apparatus comprising
a) magnet means (10) adapted to provide a static magnetic field (Bₒ),
b) gradient coil means (12) adapted to provide a first magnetic field gradient (G_{z}) applied in conjunction with rf pulses (120, 140) for selecting portions of said body along the Z direction to be excited by said rf pulses (120, 140),
c) rf generating means (20, 24, 26) programmed to apply a first said rf pulse (120) to said body at a frequency band and of sufficient strength to flip by a first angle nuclear spins limited to a region adjacent to said slab (100) in the Z direction;
characterised in that said rf generating means (20, 24, 26) is programmed to apply said first rf pulse (120) just prior to a period of rapid flow, and to apply a second said rf pulse (140) to said body during a period of quiescent flow, after moving material in said slab (100) has been allowed to flow from said slab (100) and moving material from said region has been allowed to flow into said slab (100), said second rf pulse (140) having a frequency band and sufficient strength to flip nuclear spins limited to said slab (100) by a second angle suitable for generating a signal, and by
d) means (26, 28, 30, 20) to obtain first image data in an X-Z image projection plane from said nuclear spins flipped by said second rf pulse (140),
e) said rf generating means (20, 24, 26) being further programmed to apply a third said rf pulse to said body during a period of quiescent flow, after moving material in said slab has been allowed to flow from said slab (100) and moving material from said region has been allowed to flow into said slab (100), said third rf pulse having a frequency band and sufficient strength to flip nuclear spins limited to said slab (100) by said second angle suitable for generating a signal,
f) means (26, 28, 30, 20) to obtain second image data in an X-Z image projection plane from said nuclear spins flipped by said third rf pulse,
g) processing means (20) programmed to subtract said first image data from said second image data to obtain third image data of material moving through said slab (100), and
h) means (20) for reconstructing an X-Z projection image using said third image data, after completion of the data acquisition by means of a two dimensional imaging technique.

10. Magnetic resonance apparatus for imaging material in an X-Y-Z orthogonal axis system wherein said material moves by pulsatile flow predominantly in a direction Z through a slab (100) extending substantially perpendicularly to the Z direction in a body, said apparatus comprising
a) magnet means (10) adapted to provide a static magnetic field (Bₒ),
b) gradient coil means (12) adapted to provide a first magnetic field gradient (G_{z}) applied in conjunction with rf pulses (120, 140) for selecting portions of said body along the Z direction to be excited by said rf pulses (120, 140),
c) rf generating means (20, 24, 26) programmed to apply a first said rf pulse (120) to said body at a frequency band and of sufficient strength to flip by a first angle nuclear spins limited to said slab (100), and to apply a second said rf pulse (140) to said body, after allowing moving material in said slab to flow from said slab and moving material outside of said slab (100) to flow into said slab (100), said second rf pulse (140) having a frequency band and a sufficient strength to flip nuclear spins limited to said slab (100) by a second angle suitable for generating a signal, and
d) means (26, 28, 30, 20) to obtain first image data in an X-Z image projection plane from said nuclear spins flipped by said second rf pulse (140),
characterised in that
e) said rf generating means (20, 24, 26) is programmed to apply said first rf pulse (120) just prior to a period of rapid flow and to apply said second rf pulse during a period of quiescent flow, and is further programmed to apply a third said rf pulse to said body just prior to a period of rapid flow and at a frequency band that is non-selective of said slab (100) and of sufficient strength to flip nuclear spins in said body, but not limited to said slab (100), by said first angle, and to apply a fourth said rf pulse identical to said second rf pulse to said body during a period of quiescent flow after allowing moving material in said slab to flow from said slab and moving material outside of said slab (100) to flow into said slab (100),
and further characterised by
f) means (26, 28, 30, 20) to obtain second image data in an X-Z image projection plane from said nuclear spins flipped by said fourth rf pulse,
g) processing means (20) programmed to subtract said first image data from said second image data to obtain third image data of material moving through said slab (100), and
h) means (20) for reconstructing an X-Z projection image using said third image data, after completion of the data acquisition by means of a two dimensional imaging technique.

11. Magnetic resonance apparatus as defined by Claim 10, wherein said rf generating means is programmed to apply said third rf pulse to said body at a frequency band that, instead of being non-selective of said slab, is selective of said slab (100) and a region adjacent to said slab (100) in the Z direction.

## Patentansprüche

1. Verfahren zum Abbilden von Material in einem X-Y-Z-Orthogonalachsensystem unter Anwendung magnetischer Resonanz, wobei sich das Material in einem pulsierenden Strom vorwiegend in Z-Richtung durch einen sich im wesentlichen senkrecht zur Z-Richtung in einem Körper erstreckenden Quader (100) bewegt, mit folgenden Schritten:
a) Anordnen des Körpers in einem Magnetfeld (B₀) mit einem ersten in Verbindung mit Hochfrequenz-(HF)-Impulsen (120, 140) angelegten Magnetfeldgradienten (G_{z}) zum Auswählen von Teilen des Körpers längs der Z-Richtung, die durch die HF-Impulse (120, 140) erregt werden sollen,
b) Anlegen eines ersten HF-Impulses (120) an den Körper mit einem Frequenzband und ausreichender Stärke, um Kernspins begrenzt auf einen Bereich in Z-Richtung angrenzend an den Quader um einen ersten Winkel zu kippen,
c) für eine ausreichende Zeit Abwarten, bis das sich bewegende Material im Quader (100) aus dem Quader (100) und sich bewegendes Material aus dem Bereich in den Quader (100) geflossen ist,
dadurch **gekennzeichnet**, daß der HF-Impuls (120) unmittelbar vor einer Periode schneller Strömung angelegt wird, und durch die Schritte:
d) Anlegen eines zweiten HF-Impulses (140) an den Körper während einer Periode ruhiger Strömung mit einem Frequenzband und ausreichender Stärke, um Kernspins begrenzt auf den Quader (100) um einen zweiten, zur Erzeugung eines Signals geeigneten Winkel zu kippen,
e) Ermitteln erster Bilddaten in einer X-Z-Bildprojektionsebene von den durch den zweiten HF-Impuls (140) gekippten Kernspins,
f) Wiederholen des Schritts c ohne Erregen des Bereichs,
h) Wiederholen von Schritt d,
i) Ermitteln zweiter Bilddaten in einer X-Z-Bildprojektionsebene von den durch den HF-Impuls des Schritts h gekippten Kernspins,
j) Subtrahieren der ersten Bilddaten von den zweiten Bilddaten zum Ermitteln dritter Bilddaten des sich durch den Quader (100) bewegenden Materials, und
k) Rekonstruieren eines X-Z-Projektionsbildes unter Verwendung der dritten Bilddaten nach Vollenden der Datengewinnung mittels einer zweidimensionalen Abbildungstechnik.

2. Verfahren nach Anspruch 1, wobei der Schritt d zur Spin-Echosignalerfassung das Anlegen eines 90°-HF-Impulses und eines 180°-HF-Impulses beinhaltet.

3. Verfahren zum Abbilden von Material in einem X-Y-Z-Orthogonalachsensystem unter Anwendung magnetischer Resonanz, wobei sich das Material in einem pulsierenden Strom vorwiegend in Z-Richtung durch einen sich im wesentlichen senkrecht zur Z-Richtung in einem Körper erstreckenden Quader (100) bewegt, mit folgenden Schritten:
a) Anordnen des Körpers in einem Magnetfeld (B₀) mit einem ersten in Verbindung mit Hochfrequenz (HF)-Impulsen (120, 140) angelegten Magnetfeldgradienten (G_{z}) zum Auswählen des Körpers längs der Z-Richtung, die durch die Hf-Impulse (120, 140) erregt werden sollen,
b) Anlegen eines ersten HF-Impulses (120) an den Körper mit einem Frequenzband und ausreichender Stärke um Kernspins begrenzt auf einen Bereich in Z-Richtung angrenzend an den Quader um einen ersten Winkel zu kippen,
c) für eine ausreichende Zeit Abwarten, bis das sich bewegende Material im Quader (100) aus dem Quader (100) und sich bewegendes Material aus dem Bereich in den Quader (100) geflossen ist,
d) Anlegen eines zweiten HF-Impulses (140) an den Körper mit einem Frequenzband und ausreichender Stärke, um Kernspins begrenzt auf den Quader (100) um einen zweiten, zur Erzeugung eines Signals geeigneten Winkel zu kippen,
e) Ermitteln erster Bilddaten in einer X-Z-Bildprojektionsebene von den durch den zweiten HF-Impuls (140) gekippten Kernspins,
dadurch **gekennzeichnet**, daß der erste HF-Impuls unmittelbar vor einer Periode schneller Strömung und der zweite HF-Impuls während einer Periode ruhiger Strömung angelegt wird, und ferner durch die Schritte:
f) Anlegen eines dritten HF-Impulses an den Körper unmittelbar vor einer Periode schneller Strömung und mit einem Frequenzband, das für den Quader (100) nicht selektiv ist, und ausreichender Stärke, um Kernspins in dem Körper, jedoch nicht begrenzt auf den Quader (100), um den ersten Winkel zu kippen,
g) Wiederholen von Schritt c,
h) Wiederholen von Schritt d,
i) Ermitteln zweiter Bilddaten in einer X-Z-Bildprojektionsebene von den durch den HF-Impuls des Schritts h gekippten Kernspins,
j) Subtrahieren der ersten Bilddaten von den zweiten Bilddaten zum Ermitteln dritter Bilddaten des sich durch den Quader (100) bewegenden Materials, und
k) Rekonstruieren eines X-Z-Projektionsbildes unter Verwendung der dritten Bilddaten nach Vollenden der Datengewinnung mittels einer zweidimensionalen Abbildungstechnik.

4. Verfahren nach Anspruch 3, wobei der dritte HF-Impuls statt nicht-selektiv für den Quader selektiv ist für den Quader (100) und einen Bereich in Z-Richtung angrenzend an den Quader (100).

5. Verfahren nach Anspruch 3, wobei der Schritt d das Kippen von Kernspins sich bewegenden Materials umfaßt, das während des Schritts c in den Quader (100) strömt.

6. Verfahren nach Anspruch 3, wobei der Schritt b ferner das Kippen von Kernspins in einem ersten Bereich in Z-Richtung angrenzend an den Quader (200) und der Schritt j das Ermitteln dritter Bilddaten sich bewegenden Materials beinhaltet, das aus einem bezüglich des ersten Bereichs auf der gegenüberliegenden Seite des Quaders (200) in den Quader (200) strömt.

7. Verfahren nach Anspruch 1 oder 3, wobei der erste Winkel etwa 180° und der zweite Winkel etwa 90° beträgt.

8. Verfahren nach Anspruch 7, soweit dieser auf Anspruch 3 bezogen ist, wobei die Schritte d und h auftreten, wenn die magnetischen Momente erregten statischen Materials etwa gleich Null sind.

9. Magnetresonanzvorrichtung zum Abbilden von Material in einem X-Y-Z-Orthogonalachsensystem, wobei sich das Material in einem pulsierenden Strom vorwiegend in Z-Richtung durch einen sich im wesentlichen senkrecht zur Z-Richtung in einem Körper erstreckenden Quader (100) bewegt, mit
a) einer Magneteinrichtung (10) zur Erzeugung eines statischen Magnetfeldes (B₀),
b) einer Gradienteneinrichtung (12) zur Erzeugung eines ersten Magnetfeldgradienten (G_{z}), der zum Auswählen durch die HF-Impulse (120, 140) längs der Z-Richtung zu erregender Teile des Körpers angelegt wird,
c) HF-Erzeugungseinrichtungen (20, 24, 26), die so programmiert sind, daß der erste HF-Impuls (120) mit einem Frequenzband und ausreichender Stärke an den Körper angelegt wird, um Kernspins begrenzt auf einen Bereich in Z-Richtung angrenzend an den Quader um einen ersten Winkel zu kippen,
dadurch **gekennzeichnet**, daß die HF-Erzeugungseinrichtung (20, 24, 26) so programmiert ist, daß der erste HF-Impuls (120) unmittelbar vor einer Periode schnellen Stromes und der zweite HF-Impuls (140) während einer Periode ruhigen Stromes an den Körper angelegt wird, nachdem bewegliches Material im Quader (100) aus dem Quader (100) heraus und bewegliches Material aus dem Bereich in den Quader (100) fließen konnte, wobei der zweite HF-Impuls (140) ein Frequenzband und ausreichende Stärke haben, um Kernspins begrenzt auf den Quader (100) um einen zweiten, zur Erzeugung eines Signals geeigneten Winkel zu kippen, und durch
d) Einrichtungen (26, 28, 39, 20) zum Ermitteln erster Bilddaten in einer X-Z-Bildprojektionsebene von den durch den zweiten HF-Impuls (140) gekippten Kernspins,
e) wobei die HF-Erzeugungseinrichtungen (20, 24, 26) ferner so programmiert sind, daß während einer Periode ruhigen Stromes an den Körper ein dritter HF-Impuls angelegt wird, nachdem bewegliches Material im Quader aus dem Quader (100) strömen und sich bewegendes Material aus dem Bereich in den Quader (100) strömen konnte, wobei der dritte HF-Impuls ein Frequenzband und eine ausreichende Stärke haben, um Kernspins begrenzt auf den Quader (100) um den zweiten Winkel zu kippen, der ausreicht, ein Signal zu erzeugen,
f) Einrichtungen (26, 28, 30, 20) zum Ermitteln zweiter Bilddaten in einer X-Z-Bildprojektionsebene aus den durch den dritten HF-Impuls gekippten Kernspins,
g) eine Verarbeitungseinrichtung (20), die so programmiert ist, daß zur Gewinnung dritter Bilddaten des sich durch den Quader (100) bewegenden Materials die ersten Bilddaten von den zweiten Bilddaten subtrahiert werden, und
h) eine Einrichtung (20) zum Rekonstruieren eines X-Z-Projektionsbildes unter Verwendung der dritten Bilddaten nach Vollendung der Datengewinnung mittels einer zweidimensionalen Abbildungstechnik.

10. Magnetresonanzvorrichtung zum Abbilden von Material in einem X-Y-Z-Orthogonalachsensystem, wobei sich das Material in einem pulsierenden Strom vorwiegend in Z-Richtung durch einen sich im wesentlichen senkrecht zur Z-Richtung in einem Körper erstreckenden Quader bewegt, mit
a) einer Magneteinrichtung (10) zur Erzeugung eines statischen Magnetfeldes (B₀),
b) einer Gradientspuleneinrichtung (12) zur Erzeugung eines ersten Magnetfeldgradienten (G_{z}), der zum Auswählen durch die HF-Impulse (120, 140) längs der Z-Richtung zu erregender Teile des Körpers angelegt wird,
c) HF-Erzeugungseinrichtungen (20, 24, 26), die so programmiert sind, daß der erste HF-Impuls (120) mit einem Frequenzband und ausreichender Stärke an den Körper angelegt wird, um Kernspins begrenzt auf einen Bereich in Z-Richtung angrenzend an den Quader (100) um einen ersten Winkel zu kippen, und zum Anlegen des zweiten HF-Impulses (140) an den Körper, nachdem das sich bewegende Material im Quader aus dem Quader herausströmen und das sich bewegende Material außerhalb des Quaders (100) in den Quader (100) hineinströmen konnte, wobei der zweite HF-Impuls (140) ein Frequenzband und eine ausreichende Stärke hat, um auf den Quader (100) begrenzte Kernspins um einen zur Erzeugung eines Signals geeigneten Winkel zu kippen, und
d) Einrichtungen (26, 28, 30, 20) zum Ermitteln erster Bilddaten in einer X-Z-Bildprojektionsebene von den durch den zweiten HF-Impuls (140) gekippten Kernspins,
dadurch **gekennzeichnet,** daß
die HF-Erzeugungseinrichtung (20, 24, 26) so programmiert ist, daß der erste HF-Impuls (120) unmittelbar vor einer Periode ruhiger Strömung und ein dritter HF-Impuls unmittelbar vor einer Periode schneller Strömung angelegt wird, und bei einem Frequenzband, das nicht selektiv für den Quader (100) und von ausreichender Stärke ist, daß Kernspins im Körper, jedoch nicht begrenzt auf den Quader (100), um den ersten Winkel gekippt werden, und zum Anlegen eines vierten HF-Impulses, der identisch mit dem zweiten HF-Impuls ist, an den Körper während einer Periode ruhiger Strömung, nachdem sich bewegendes Material außerhalb des Quaders (100) in den Quader (100) strömen konnte,
ferner **gekennzeichnet** durch
f) Einrichtungen (26, 28, 30, 20) zum Ermitteln zweiter Bilddaten in einer X-Z-Bildprojektionsebene aus den durch den dritten HF-Impuls gekippten Kernspins,
g) eine Verarbeitungseinrichtung (20), die so programmiert ist, daß zur Gewinnung dritter Bilddaten des sich durch den Quader (100) bewegenden Materials die ersten Bilddaten von den zweiten Bilddaten subtrahiert werden, und
h) eine Einrichtung (20) zum Rekonstruieren eines X-Z-Projektionsbildes unter Verwendung der dritten Bilddaten nach Vollendung der Datengewinnung mittels einer zweidimensionalen Abbildungstechnik.

11. Magnetresonanzvorrichtung nach Anspruch 10, wobei die HF-Erzeugungseinrichtung so programmiert ist, daß der dritte HF-impuls mit einem Frequenzband an den Körper angelegt wird, das statt nicht-selektiv für den Quader selektiv ist für den Quader (100) und für einen in Z-Richtung an den Quader (100) angrenzenden Bereich.

## Revendications

1. Procédé d'imagerie d'un matériau dans un système d'axes orthogonaux X-Y-Z utilisant des techniques de résonance magnétique, dans lequel ledit matériau se déplace par écoulement pulsatile de façon prédominante dans une direction Z à travers une tranche (100) s'étendant sensiblement perpendiculairement à la direction Z dans un organisme; ledit procédé comprenant les étapes consistant à:
a) placer ledit organisme dans un champ magnétique (Bₒ) incluant un premier gradient de champ magnétique (G_{z}) appliqué en association avec des impulsions RF (120, 140) pour sélectionner des parties dudit organisme suivant la direction Z afin qu'elles soient excitées par lesdites impulsions RF (120, 140),
b) appliquer une première desdites impulsions RF (120) audit organisme avec une bande de fréquences et d'une intensité suffisante pour faire basculer d'un premier angle des spins nucléaires limités à une région adjacente à ladite tranche (100) dans la direction Z,
c) laisser un temps suffisant au matériau en mouvement dans ladite tranche (100) pour s'écouler hors de ladite tranche (100) et pour que le matériau en mouvement provenant de ladite région s'écoule vers l'intérieur de ladite tranche (100) ;
caractérisé en ce que ladite première impulsion RF (120) est appliquée immédiatement avant une période d'écoulement rapide, et par les étapes consistant à:
d) appliquer une deuxième desdites impulsions RF (140) audit organisme pendant une période d'écoulement de repos et avec une bande de fréquences et une intensité suffisantes pour faire basculer des spins nucléaires limités à ladite tranche (100), d'un second angle approprié pour générer un signal,
e) obtenir des premières données d'image dans un plan de projection d'image X-Z à partir desdits spins nucléaires basculés par ladite deuxième impulsion RF (140),
f) répéter l'étape c sans exciter ladite région,
h) répéter l'étape d,
i) obtenir des deuxièmes données d'image dans un plan de projection d'image X-Z à partir desdits spins nucléaires basculés par l'impulsion RF de l'étape h,
j) soustraire lesdites premières données d'image auxdites deuxièmes données d'images pour obtenir des troisièmes données d'images d'un matériau en mouvement à travers ladite tranche (100), et
k) reconstruire une image en projection X-Z en utilisant lesdites troisièmes données d'images, après achèvement de l'acquisition des données au moyen d'une technique d'imagerie bidimensionnelle.

2. Procédé selon la revendication 1, dans lequel l'étape d comporte l'application d'une impulsion RF à 90° et d'une impulsion à 180° pour la détection d'un signal d'écho de spin.

3. Procédé d'imagerie d'un matériau dans un système d'axes orthogonaux X-Y-Z utilisant des techniques de résonance magnétique, dans lequel ledit matériau se déplace par écoulement pulsatile de façon prédominante dans une direction Z à travers une tranche (100) s'étendant sensiblement perpendiculairement à la direction Z dans un organisme, ledit procédé comprenant les étapes consistant à:
a) placer ledit organisme dans un champ magnétique (Bₒ) incluant un premier gradient de champ magnétique (G_{z}) appliqué en association avec des impulsions RF (120, 140) pour sélectionner des parties dudit organisme suivant la direction Z pour qu'elles soient excitées par lesdites impulsions RF (120, 140),
b) appliquer une première desdites impulsions RF (120) audit organisme avec une bande de fréquences et une intensité suffisantes pour faire basculer d'un premier angle des spins nucléaires limités à ladite tranche (100) ;
c) laisser un temps suffisant au matériau en mouvement dans ladite tranche pour s'écouler hors de ladite tranche, et au matériau situé à l'extérieur de ladite tranche (100) pour s'écouler vers l'intérieur de ladite tranche (100);
d) appliquer une deuxième desdites impulsions RF (140) audit organisme avec une bande de fréquences et une intensité suffisantes pour faire basculer des spins nucléaires limités à ladite tranche (100), d'un second angle approprié pour générer un signal,
e) obtenir des premières données d'image dans un plan de projection d'image X-Z à partir desdits spins nucléaires basculés par ladite deuxième impulsion RF (140),
caractérisé en ce que ladite première impulsion RF est appliquée immédiatement avant une période d'écoulement rapide et en ce que ladite seconde impulsion RF est appliquée pendant une période d'écoulement de repos, et par les étapes consistant à:
f) appliquer une troisième desdites impulsions RF audit organisme immédiatement avant une période d'écoulement rapide avec une bande de fréquences qui n'est pas sélective vis-à-vis de ladite tranche (100) et une intensité suffisante pour faire basculer dudit premier angle des spins nucléaires dans ledit organisme, mais sans limitation à ladite tranche (100),
g) répéter l'étape c,
h) répéter l'étape d,
i) obtenir des deuxièmes données d'image dans un plan de projection d'image X-Z à partir desdits spins nucléaires basculés par l'impulsion RF de l'étape h,
j) soustraire lesdites premières données d'images auxdites deuxièmes données d'image pour obtenir des troisièmes données d'images du matériau se déplaçant à travers ladite tranche (100), et
k) reconstruire une image en projection X-Z en utilisant lesdites troisièmes données d'images, après achèvement de l'acquisition des données au moyen d'une technique d'imagerie bidimensionnelle.

4. Procédé selon la revendication 3, dans lequel ladite troisième impulsion RF, au lieu d'être non sélective vis-à-vis de ladite tranche, est sélective vis-à-vis de ladite tranche (100) et d'une région adjacente à ladite tranche (100) dans la direction Z.

5. Procédé selon la revendication 3, dans lequel l'étape d comprend le basculement de spins nucléaires du matériau en mouvement qui s'écoule vers l'intérieur de ladite tranche (100) pendant l'étape c.

6. Procédé selon la revendication 3, dans lequel l'étape b comprend en outre le basculement de spins nucléaires dans une première région adjacente à ladite tranche (200) dans la direction Z, et dans lequel l'étape j obtient des troisièmes données d'image du matériau en mouvement s'écoulant vers l'intérieur de ladite tranche (200) en provenance d'une région située du côté de ladite tranche (200) qui est opposé à ladite première région.

7. Procédé selon les revendications 1 ou 3, dans lequel ledit premier angle est d'environ 180° et ledit second angle est d'environ 90°.

8. Procédé selon la revendication 7, dans la mesure où la revendication 7 se réfère à la revendication 3, dans lequel lesdites étapes d) et h) se produisent lorsque les moments magnétiques du matériau statique excité sont pratiquement nuls.

9. Appareil à résonance magnétique pour l'imagerie d'un matériau dans un système d'axes orthogonaux X-Y-Z, dans lequel ledit matériau se déplace par écoulement pulsatile de façon prédominante dans une direction Z à travers une tranche (100) s'étendant sensiblement perpendiculairement à la direction Z dans un organisme, ledit appareil comprenant:
a) un moyen à aimant (10) adapté à produire un champ magnétique statique (Bₒ),
b) un moyen à gradient (12) adapté à produire un premier gradient de champ magnétique (G_{z}) appliqué en association avec des impulsions RF (120, 140) pour sélectionner des parties dudit organisme suivant la direction Z pour qu'elles soient excitées par lesdites impulsions RF (120, 140),
c) un moyen générateur RF (20, 24, 26) programmé pour appliquer une première desdites impulsions RF (120) audit organisme avec une bande de fréquences et une intensité suffisantes pour faire basculer d'un premier angle des spins nucléaires limités à une région adjacente à ladite tranche (100) dans la direction Z;
caractérisé en ce que ledit moyen générateur RF (20, 24, 26) est programmé pour appliquer ladite première impulsion RF (120) immédiatement avant une période d'écoulement rapide, et pour appliquer une deuxième desdites impulsions RF (140) audit organisme pendant une période d'écoulement de repos, après avoir permis au matériau en mouvement dans ladite tranche (100) de s'écouler hors de ladite tranche (100) et au matériau en mouvement en provenance de ladite région de s'écouler vers l'intérieur de ladite tranche (100), ladite deuxième impulsion RF (140) ayant une bande de fréquences et une intensité suffisantes pour faire basculer des spins nucléaires limités à ladite tranche (100) d'un second angle approprié pour générer un signal, et par:
d) un moyen (26, 28, 30, 20) pour obtenir des premières données d'images dans un plan de projection d'image X-Z à partir desdits spins nucléaires basculés par ladite deuxième impulsion RF (140),
e) ledit moyen générateur RF (20, 24, 26) étant en outre programmé pour appliquer une troisième desdites impulsions RF audit organisme pendant une période d'écoulement de repos, après avoir permis au matériau en mouvement dans ladite tranche de s'écouler hors de ladite tranche (100) et au matériau en mouvement provenant de ladite région de s'écouler vers l'intérieur de ladite tranche (100), ladite troisième impulsion RF ayant une bande de fréquences et une intensité suffisantes pour faire basculer des spins nucléaires limités à ladite tranche (100) d'un second angle approprié pour générer un signal,
f) un moyen (26, 28, 30, 20) pour obtenir des deuxièmes données d'images dans un plan de projection d'image X-Z à partir desdits spins nucléaires basculés par ladite troisième impulsion RF,
g) un moyen de traitement (20) programmé pour soustraire lesdites premières données d'image auxdites secondes données d'image afin d'obtenir des troisièmes données d'image du matériau en mouvement à travers ladite tranche (100), et
h) un moyen (20) pour reconstruire une image en projection X-Z par utilisation desdites troisièmes données d'image, après achèvement de l'acquisition des données, au moyen d'une technique d'imagerie bidimensionnelle.

10. Appareil à résonance magnétique pour l'imagerie d'un matériau dans un système d'axes orthogonaux X-Y-Z dans lequel ledit matériau se déplace par écoulement pulsatile de façon prédominante dans une direction Z à travers une tranche (100) s'étendant sensiblement perpendiculairement à la direction Z dans un organisme, ledit appareil comprenant:
a) un moyen à aimant (10) adapté à produire un champ magnétique statique (Bₒ),
b) un moyen à gradient (12) adapté à produire un premier gradient de champ magnétique (G_{z}) appliqué en association avec des impulsions RF (120, 140) pour sélectionner des parties dudit organisme suivant la direction Z afin qu'elles soient excitées par lesdites impulsions RF (120, 140),
c) un moyen générateur RF (20, 24, 26) programmé pour appliquer une première desdites impulsions RF (120) audit organisme avec une bande de fréquences et une intensité suffisantes pour faire basculer d'un premier angle des spins nucléaires limités à ladite tranche (100), et pour appliquer une deuxième desdites impulsions RF (140) audit organisme après avoir permis au matériau en mouvement dans ladite tranche de s'écouler hors de ladite tranche et au matériau en mouvement à l'extérieur de ladite tranche (100) de s'écouler vers l'intérieur de ladite tranche (100), ladite deuxième impulsion RF (140) ayant une bande de fréquences et une intensité suffisantes pour faire basculer des spins nucléaires limités à ladite tranche (100) d'un second angle approprié pour générer un signal, et
d) un moyen (26, 28, 30, 20) pour obtenir des premières données d'images dans un plan de projection d'image X-Z à partir desdits spins nucléaires basculés par ladite seconde impulsion RF (140),
caractérisé en ce que
e) ledit moyen générateur RF (20, 24, 26) est programmé pour appliquer ladite première impulsion RF (120) immédiatement avant une période d'écoulement rapide et pour appliquer ladite deuxième impulsion RF pendant une période d'écoulement de repos; et est en outre programmé pour appliquer une troisième desdites impulsions RF audit organisme immédiatement avant une période d'écoulement rapide avec une bande de fréquences qui n'est pas sélective vis-à-vis de ladite tranche (100) et une intensité suffisante pour faire basculer dudit premier angle des spins nucléaires dans ledit organisme, mais sans limitation audit organisme (100), et pour appliquer une quatrième desdites impulsions RF identique à ladite deuxième impulsion RF audit organisme pendant une période d'écoulement de repos après avoir permis au matériau en mouvement dans ladite tranche de s'écouler hors de ladite tranche et au matériau en mouvement à l'extérieur de ladite tranche (100) de s'écouler vers l'intérieur de ladite tranche (100),
et caractérisé en outre par
f) un moyen (26, 28, 30, 20) pour obtenir des deuxièmes données d'image dans un plan de projection d'image X-Z à partir desdits spins nucléaires basculés par ladite quatrième impulsion RF,
g) un moyen de traitement (20) programmé pour soustraire lesdites premières données d'image auxdites deuxièmes données d'image pour obtenir des troisièmes données d'image du matériau en mouvement à travers ladite tranche (100), et
h) un moyen (20) pour reconstruire une image en projection X-Z en utilisant lesdites troisièmes données d'image, après achèvement de l'acquisition des données au moyen d'une technique d'imagerie bidimensionnelle.

11. Appareil à résonance magnétique selon la revendication 10, dans lequel ledit moyen générateur RF est programmé pour appliquer ladite troisième impulsion RF audit organisme, avec une bande de fréquences qui, au lieu d'être non sélective vis-à-vis de ladite tranche, est sélective vis-à-vis de ladite tranche (100) et d'une région adjacente à ladite tranche (100) dans la direction Z.
